# EUROPEAN PATENT APPLICATION

(11) **EP 4 509 641 A1**
(43) Date of publication of application: **19.02.2025**
(21) Application number: 23788012.5
(22) Date of filing: 14.02.2023
(51) Int. Cl.: C23G 1/10, C11D 7/18, C11D 7/26

(54) **CLEANING AGENT, CLEANING METHOD AND SUPPLEMENTARY LIQUID**

(30) Priority: 14.04.2022 JP 2022066892
(71) Applicant: MEC COMPANY., LTD., Amagasaki-shi, Hyogo 660-0822 (JP)
(72) Inventor: SADANAGA, Kosuke, Amagasaki-shi, Hyogo 660-0822 (JP); HAYASHIZAKI, Masahiro, Amagasaki-shi, Hyogo 660-0822 (JP); AZUI, Momoko, Amagasaki-shi, Hyogo 660-0822 (JP); TOJIMA, Mami, Amagasaki-shi, Hyogo 660-0822 (JP)
(74) Representative: TBK
(86) International application number: PCT/JP2023/004943
(87) International publication number: WO 2023/199589

(57) **Abstract**

An object is to provide a cleaning agent capable of removing an organic substance and copper oxide that are attached to a copper wiring surface while suppressing etching of copper. The cleaning agent contains a water-soluble carboxylic acid and hydrogen peroxide, the concentration of hydrogen peroxide is less than 0.75% by weight, and the pH of the cleaning agent is less than 2.5. Copper oxide can be removed from the copper wiring surface by the water-soluble carboxylic acid. Organic substances attached to the copper wiring surface can be removed by hydrogen peroxide. This is considered to be because hydrogen peroxide reacts with the water-soluble carboxylic acid to produce a percarboxylic acid in the cleaning agent. Etching of copper wiring can also be suppressed. This is considered to be because the water-soluble carboxylic acid is adsorbed onto the copper surface. Since it is less than 0.75% by weight, etching can be further suppressed. Since the pH is less than 2.5, a greater amount of copper oxide can be removed.

## Description

### TECHNICAL FIELD

The present invention relates to a cleaning agent, a cleaning method, and a supplementary liquid.

### BACKGROUND ART

During the manufacturing process of printed wiring boards, organic substances such as resin scum and fingerprint-like oil may be attached to and remain on the surface of copper wiring. The flash etching solution, namely, the etching solution for etching the seed layer between unnecessary conductors when printed wiring boards are manufactured by the semi-additive process contains a nitrogen-containing heterocyclic compound (see, for example, Patent Documents 1 to 3), and the nitrogen-containing heterocyclic compound contained in the flash etching solution may remain on the surface of the copper wiring. Meanwhile, a copper oxide film may be formed on the surface of the copper wiring, for example, by baking.

### PRIOR ART DOCUMENTS

### PATENT DOCUMENTS

Patent Document 1: JP-A-2006-9122
Patent Document 2: Japanese Patent No. 5,576,525
Patent Document 3: JP-A-2015-120970
Patent Document 4: Japanese Patent No. 6,779,557

### SUMMARY OF THE INVENTION

### PROBLEMS TO BE SOLVED BY THE INVENTION

If a film for improving close contact properties (which may also be called adhesive properties) between the copper wiring and the resin member (hereinafter, sometimes referred to as "close contact property improving film"; see, for example, Patent Document 4) is formed on the surface of the copper wiring while such organic substances and copper oxides remain on the surface of the copper wiring, the close contact properties may not be effectively improved. Meanwhile, if the copper wiring is roughened with a micro-etching solution (namely, an etching solution for roughening the surface of the copper wiring) while such organic substances and copper oxides remain on the surface of the copper wiring, the roughening may not be effectively performed.

As a cleaning method of the copper surface, a method may be conceivable in which the oil attached to the copper surface is removed with an alkaline cleaning agent and then copper oxide is removed with an acid-based micro-etching solution.

However, micro-etching solutions actively dissolve not only copper oxide but also copper itself (for example, copper that has been covered with the copper oxide film), and thus cleaning using micro-etching solutions may not be compatible with the ongoing miniaturization of copper wiring. In other words, taking into consideration future advances in miniaturization, it may become impossible to use micro-etching solutions in cleaning applications.

In addition to this, the above-described cleaning method (that is, cleaning with an alkaline cleaning agent is performed and then cleaning with an acid-based micro-etching solution is performed) requires time and effort since the removal of oil and the removal of copper oxide are carried out separately.

An object of the present invention is to provide a cleaning agent capable of removing an organic substance (hereinafter, sometimes referred to as "organic residue") and copper oxide that are attached to a copper wiring surface while suppressing etching of copper.

### MEANS FOR SOLVING THE PROBLEMS

In order to solve this problem, the present invention includes the configuration of the following [1].
[1] A cleaning agent for substrates including copper wiring, containing
   a water-soluble carboxylic acid; and
   hydrogen peroxide, in which
   a concentration of the hydrogen peroxide is less than 0.75% by weight, and
   a pH of the cleaning agent is less than 2.5.

Here, the term "cleaning agent for substrates including copper wiring" refers to an aqueous solution for cleaning substrates including copper wiring.

"Copper" of "copper wiring" may be copper itself or a copper alloy. In other words, the "copper wiring" may be wiring formed of copper or wiring formed of a copper alloy.

It is preferable that the present invention further includes the configuration of the following [2] and after.

[2] The cleaning agent according to [1], which substantially does not contain a nitrogen-containing heterocyclic compound.
[3] The cleaning agent according to [1], which does not comprise a nitrogen-containing heterocyclic compound.
[4] The cleaning agent according to any one of [1] to [3], wherein the water-soluble carboxylic acid is at least one carboxylic acid selected from the group consisting of formic acid, acetic acid, propionic acid, glycolic acid, oxalic acid, malonic acid, succinic acid, maleic acid, lactic acid, malic acid, citric acid, glycine, α-alanine, and β-alanine.
[5] The cleaning agent according to any one of [1] to [4], wherein a concentration of the water-soluble carboxylic acid is 0.2% by weight or more.
[6] The cleaning agent according to any one of [1] to [5], wherein a concentration of the hydrogen peroxide is 0.05% by weight or more.
[7] The cleaning agent according to any one of [1] to [6], wherein a chloride ion concentration is 0.05 ppm or more.
[8] The cleaning agent according to any one of [1] to [7], which is used to clean the substrate before a film for improving close contact properties between the copper wiring and a resin member is formed on a surface of the copper wiring.
[9] A cleaning method comprising a step of cleaning a substrate including copper wiring with the cleaning agent according to any one of any one of [1] to [8].
[10] A supplementary liquid to be added to the cleaning agent according to any one of [1] to [8] when the cleaning agent is used continuously or repeatedly, the supplementary liquid comprising:
   a water-soluble carboxylic acid; and
   hydrogen peroxide, wherein
   a pH of the supplementary liquid is less than 2.5.

### MODE FOR CARRYING OUT THE INVENTION

### <1. Introduction>

The cleaning agent of the present embodiment, that is, the cleaning agent for substrates including copper wiring contains
a water-soluble carboxylic acid; and
hydrogen peroxide,
the concentration of hydrogen peroxide is less than 0.75% by weight, and
the pH of the cleaning agent is less than 2.5.

The cleaning agent of the present embodiment contains a water-soluble carboxylic acid, and thus can dissolve copper oxide on the copper wiring surface (namely, the copper oxide film on the copper wiring surface). Therefore, copper oxide can be removed from the copper wiring surface.

Moreover, the cleaning agent of the present embodiment further contains hydrogen peroxide, and thus can remove organic substances attached to the copper wiring surface. This is considered to be because hydrogen peroxide reacts with the water-soluble carboxylic acid to produce a percarboxylic acid, a strong oxidizing agent, in the cleaning agent, and the organic substances are decomposed by the percarboxylic acid.

In addition, the cleaning agent of the present embodiment can suppress the dissolution of copper of copper wiring (for example, copper that has been covered with the copper oxide film). In other words, etching of copper wiring can be suppressed. This is considered to be because copper can be oxidized by hydrogen peroxide, but the water-soluble carboxylic acid is adsorbed onto the copper surface, and this suppresses the oxidation of copper by hydrogen peroxide (that is, suppresses the production of copper oxide).

Furthermore, since the concentration of hydrogen peroxide is less than 0.75% by weight, the dissolution (namely, etching) of copper by hydrogen peroxide can be further suppressed.

In addition to this, since the pH of the cleaning agent of the present embodiment is less than 2.5, a greater amount of copper oxide can be removed.

Hereinafter, the embodiments of the present invention will be described in more detail.

### <2. Cleaning agent>

The cleaning agent of the present embodiment, that is, a cleaning agent for cleaning a substrate including copper wiring, contains a water-soluble carboxylic acid. Since a water-soluble carboxylic acid is contained, copper oxide on the copper wiring surface (namely, the copper oxide film on the copper wiring surface) can be dissolved. Therefore, copper oxide can be removed from the copper wiring surface. By the water-soluble carboxylic acid, the dissolution of copper of copper wiring (for example, copper that has been covered with the copper oxide film) can also be suppressed. In other words, etching of copper wiring can be suppressed. This is considered to be because copper can be oxidized by hydrogen peroxide, but the water-soluble carboxylic acid is adsorbed onto the copper surface, and this suppresses the oxidation of copper by hydrogen peroxide (that is, suppresses the production of copper oxide).

Examples of the water-soluble carboxylic acid may include formic acid, acetic acid, propionic acid, glycolic acid, oxalic acid, malonic acid, succinic acid, maleic acid, lactic acid, malic acid, citric acid, glycine, α-alanine, and β-alanine. Among these, formic acid, acetic acid, propionic acid, succinic acid, maleic acid, lactic acid, malic acid, citric acid and glycine are more preferable, and malic acid and acetic acid are still more preferable.

The solubility of the water-soluble carboxylic acid, specifically, the solubility of the water-soluble carboxylic acid in 100 g of water at 20°C is, for example, preferably 0.5 g or more, more preferably 5 g or more, still more preferably 10 g or more, still more preferably 15 g or more.

The concentration of the water-soluble carboxylic acid is preferably 0.2% by weight or more, more preferably 0.5% by weight or more, still more preferably 1.0% by weight or more. When the concentration of the water-soluble carboxylic acid is 0.5% by weight or more, a greater amount of copper oxide can be removed from the copper wiring surface as well as a greater amount of organic residues attached to the copper wiring surface can be removed. The concentration of the water-soluble carboxylic acid may be 1.5% by weight or more, 2.0% by weight or more, or 3.0% by weight or more. Meanwhile, the concentration of the water-soluble carboxylic acid may be 40% by weight or less, 30% by weight or less, or 20% by weight or less, 15% by weight or less, or 14% by weight or less.

The cleaning agent of the present embodiment further contains hydrogen peroxide. The cleaning agent of the present embodiment further contains hydrogen peroxide, and thus can remove organic substances attached to the copper wiring surface. This is considered to be because hydrogen peroxide reacts with the water-soluble carboxylic acid to produce a percarboxylic acid, a strong oxidizing agent, in the cleaning agent, and the organic substances are decomposed by the percarboxylic acid.

The concentration of hydrogen peroxide is preferably 0.05% by weight or more, more preferably 0.07% by weight or more, still more preferably 0.10% by weight or more. When the concentration of hydrogen peroxide is 0.05% by weight or more, a greater amount of organic residues attached to the copper wiring surface can be removed. The concentration of hydrogen peroxide may be 0.20% by weight or more, or 0.30% by weight or more.

Meanwhile, the concentration of hydrogen peroxide is less than 0.75% by weight. Since the concentration of hydrogen peroxide is less than 0.75% by weight, the dissolution (namely, etching) of copper by hydrogen peroxide can be further suppressed. The concentration of hydrogen peroxide may be 0.70% by weight or less, 0.65% by weight or less, or 0.60% by weight or less.

The cleaning agent of the present embodiment preferably contains an additive for preventing the decomposition of hydrogen peroxide, that is, a hydrogen peroxide decomposition inhibitor. Examples of the hydrogen peroxide decomposition inhibitor may include cresol sulfonic acid. The concentration of the hydrogen peroxide decomposition inhibitor is preferably 0.1% by weight or more, more preferably 0.3% by weight or more. Meanwhile, the concentration of the hydrogen peroxide decomposition inhibitor is preferably 6% by weight or less, more preferably 4% by weight or less, still more preferably 2% by weight or less.

The cleaning agent of the present embodiment may contain chloride ions. The chloride ion concentration is preferably 0.05 ppm or more. When the cleaning agent of the present embodiment contains a certain amount of chloride ions (for example, 0.05 ppm or more), the effect of chloride ions that may be eluted from copper wiring on the performance of the cleaning agent can be decreased. This will be described. Copper plating solutions for forming copper wiring contain chloride ions in some cases. When a substrate including copper wiring formed with such a copper plating solution is cleaned, chloride ions may be eluted into the cleaning agent. When the cleaning agent of the present embodiment contains a certain amount of chloride ions (for example, 0.05 ppm or more) in advance, the effect of chloride ions that have been eluted from copper wiring on the performance of the cleaning agent can be decreased. The chloride ion concentration may be 0.1 ppm or more, 0.5 ppm or more, or 1 ppm or more. Meanwhile, the chloride ion concentration is preferably 30 ppm or less. The chloride ion concentration may be 20 ppm or less, 10 ppm or less, or 5 ppm or less. Examples of sources of chloride ions may include hydrochloric acid, sodium chloride, calcium chloride, potassium chloride, and ammonium chloride. Among these, sodium chloride is preferable. It is a matter of course that the ion source may be used, for example, in the form of an aqueous solution. For example, sodium chloride may be used in the form of an aqueous sodium chloride solution. As the aqueous sodium chloride solution, a chloride ion standard solution (1000 mg/L) for ion chromatography may be used.

The cleaning agent of the present embodiment may or may not contain an inorganic acid. Examples of the inorganic acid may include sulfuric acid, nitric acid, fluoroboric acid, phosphoric acid, sulfamic acid, and hydrochloric acid. In a case where an inorganic acid is added for the purpose of adjusting the pH, among the inorganic acids exemplified here, those other than hydrochloric acid are preferable. This is because hydrochloric acid affects the chloride ion concentration. In particular, sulfuric acid and nitric acid are preferable.

The cleaning agent of the present embodiment may contain other components such as a surfactant and copper ions. However, it is preferable that the cleaning agent of the present embodiment does not contain a surfactant. It is preferable that the cleaning agent of the present embodiment does not contain copper ions.

It is preferable that the cleaning agent of the present embodiment substantially does not contain a nitrogen-containing heterocyclic compound. This is because a nitrogen-containing heterocyclic compound is adsorbed to copper wiring, and as a result, this may decrease the close contact properties between a substrate (namely, a substrate including copper wiring) and a resin member (for example, a build-up film). Here, "substantially does not contain a nitrogen-containing heterocyclic compound" means that the concentration of a nitrogen-containing heterocyclic compound is 0% by weight or more and 0.0001% by weight or less.

It is more preferable that the cleaning agent of the present embodiment does not contain a nitrogen-containing heterocyclic compound. This is because it is possible to avoid the decrease in close contact properties that may be caused by the nitrogen-containing heterocyclic compound.

A nitrogen-containing heterocyclic compound is a heterocyclic compound that contains a nitrogen atom as an atom constituting the ring. The nitrogen-containing heterocyclic compound may contain other heteroatoms as atoms constituting the ring. Examples of such heteroatoms may include an oxygen atom and a sulfur atom.

Examples of the nitrogen-containing heterocyclic compound may include azoles, pyridines and morpholines. Examples of the azoles may include imidazoles, pyrazoles, triazoles, tetrazoles, and derivatives thereof. Specific examples thereof may include imidazole, 2-methylimidazole, 1,2-diethylimidazole, benzimidazole, pyrazole, triazole, and benzotriazole. In addition to these, examples thereof may include amino group-containing azoles such as 2-aminoimidazole, 3-aminopyrazole, 4-aminopyrazole, 3-amino-1,2,4-triazole, 3,5-diamino-1,2,4-triazole, and 5-aminotetrazole. Examples of the pyridines may include aminopyridines such as 2-aminopyridine, 3-aminopyridine, 4-aminopyridine, 2,3-diaminopyridine, 2,6-diaminopyridine, 2,3,6-triaminopyridine, 2,4,6-triaminopyridine, and 4,5,6-triaminopyridine. Examples of morpholines may include N-substituted morpholines such as 4-methylmorpholine, 4-ethylmorpholine, 4-propylmorpholine, 4-isopropylmorpholine, 4-isobutylmorpholine, 4-(2-hydroxyethyl)morpholine, 4-(2-aminoethyl)morpholine, 4-acetylmorpholine, N-(2-cyclohexylcarbonyloxyethyl)morpholine, 3-morpholino-1,2-propanediol, morpholinoacetonitrile, N-(2-cyanoethyl)morpholine, ethyl 3-(morpholino)propionate, 4-(2-aminoethyl)morpholine, N-cyanomethylmorpholine, N-(3-aminopropyl)morpholine, 4-(3-chloropropyl)morpholine, N-(2-hydroxypropyl)morpholine, 4-(3-hydroxypropyl)morpholine, and 1-morpholino-1-cyclohexene.

The cleaning agent of the present embodiment is an aqueous solution and contains water. As water, water from which ionic substances and impurities have been removed is preferable, and for example, ion-exchanged water, pure water, and ultrapure water are preferable. The cleaning agent of the present embodiment can be prepared by dissolving the above-described components in water.

The pH of the cleaning agent of the present embodiment is less than 2.5. Since the pH is less than 2.5, a greater amount of copper oxide can be removed. The pH may be 2.3 or less, 2.0 or less, 1.8 or less, or 1.6 or less. Meanwhile, the pH is preferably 0.2 or more, more preferably 0.4 or more, still more preferably 0.5 or more. The pH may be 0.7 or more, 0.9 or more, or 1.0 or more.

In the cleaning agent of the present embodiment, it is more preferable as the etching rate of the electroplated copper layer is lower. The etching rate of the electroplated copper layer is preferably 0.19 µm/min or less, more preferably 0.15 µm/min or less, still more preferably 0.12 µm/min or less, still more preferably 0.10 µm/min or less, still more preferably 0.08 µm/min or less, still more preferably 0.06 µm/min or less, still more preferably 0.05 µm/min or less. The etching rate of the electroplated copper layer is a value obtained by measuring the weight change after a cleaning treatment in which a copper electroplated substrate is shaken for 60 seconds in a state of being immersed in the cleaning agent at 30°C, and then performing calculation. Specifically, the etching rate of the electroplated copper layer is a value obtained by performing measurement and calculation in Examples described later.

In the cleaning agent of the present embodiment, it is more preferable as the etching rate of the sputtered copper layer is lower. The etching rate of the sputtered copper layer is preferably 170 nm/min or less, more preferably 140 nm/min or less, still more preferably 120 nm/min or less, still more preferably 100 nm/min or less, still more preferably 80 nm/min or less, still more preferably 70 nm/min or less. The etching rate of the sputtered copper layer is a value calculated based on the thicknesses (specifically, the thicknesses of the sputtered copper layer) before and after a cleaning treatment in which a substrate including a silicon wafer and the sputtered copper layer is shaken for 60 seconds in a state of being immersed in the cleaning agent at 30°C. Specifically, the etching rate of the sputtered copper layer is a value obtained by performing measurement and calculation in Examples described later.

Since the cleaning agent of the present embodiment can suppress the dissolution of copper of copper wiring (for example, copper that has been covered with the copper oxide film), the cleaning agent of the present embodiment can be used regardless of future advances in miniaturization of copper wiring. The cleaning agent of the present embodiment can suppress the dissolution of copper of copper wiring, and thus may be particularly useful when printed wiring boards that are required to have excellent signal transmission performance (for example, printed wiring boards for high frequency devices) are manufactured.

### <3. Cleaning method>

The cleaning agent of the present embodiment can be used to clean a substrate including copper wiring. In particular, the cleaning agent of the present embodiment can be suitably used to clean a substrate including copper wiring formed by removing the seed layer between unnecessary conductors (that is, removing non-circuit portions with an etching solution) when a printed wiring board is manufactured by the semi-additive process. In other words, the cleaning agent can be suitably used to clean a substrate including copper wiring formed by flash etching. Here, the semi-additive process may be a so-called modified semi-additive process (MSAP).

In particular, the cleaning agent of the present embodiment can be suitably used to clean a substrate after flash etching and before micro-etching. In other words, the cleaning agent can be suitably used to clean a substrate before the surface of copper wiring (specifically, copper wiring formed by flash etching) is roughened with a micro-etching solution. By using the cleaning agent of the present embodiment in this application (that is, to clean a substrate after flash etching and before micro-etching), organic substances and copper oxide can be removed from the copper wiring surface and it is thus possible to effectively roughen the copper wiring. As a result, the close contact properties between a substrate and a resin member (for example, a build-up film) can be improved.

The cleaning agent of the present embodiment can also be suitably used to clean a substrate after flash etching and before the formation of a film (namely, a close contact property improving film). In other words, the cleaning agent can be suitably used to clean a substrate before a film for improving the close contact properties between copper wiring and a resin member (namely, a close contact property improving film) is formed on the surface of the copper wiring. By using the cleaning agent of the present embodiment in this application (that is, to clean a substrate after flash etching and before the formation of a close contact property improving film), organic substances and copper oxide can be removed from the copper wiring surface and it is thus possible to effectively form a close contact property improving film on the copper wiring surface. As a result, the close contact properties between a substrate and a resin member (for example, a build-up film) can be improved.

The "(substrate) after flash etching" is preferably a substrate from which the flash etching solution has been removed by washing with water or the like and which has been dried if necessary, but may be a substrate to which the flash etching solution is still attached.

In order to clean a substrate including copper wiring with the cleaning agent of the present embodiment, the cleaning agent of the present embodiment is brought into contact with at least the copper wiring. In order to bring the cleaning agent of the present embodiment into contact with the copper wiring, for example, the substrate may be immersed in the cleaning agent, or the cleaning agent may be sprayed onto the substrate. In a case where the substrate is immersed in the cleaning agent for cleaning, the substrate is preferably shaken in a state of being immersed in the cleaning agent. The temperature of the cleaning agent is, for example, 5°C or more and 50°C or less. The temperature of the cleaning agent may be 10°C or more, 15°C or more, or 20°C or more. The temperature of the cleaning agent may be 45°C or less, 40°C or less, 35°C or less, or 30°C or less. The immersion time, the time during which the substrate is immersed in the cleaning agent, may be, for example, 3 seconds or more, and is preferably 10 seconds or more, more preferably 20 seconds or more. The immersion time may be 30 seconds or more, or 40 seconds or more. Meanwhile, the immersion time may be 600 seconds or less, or 300 seconds or less. The substrate immersed in the cleaning agent may be washed (for example, washed with water) to remove the cleaning agent, if necessary, and may be dried, if necessary.

### <4. Method for manufacturing printed wiring board>

The method for manufacturing a printed wiring board of the present embodiment includes a step of cleaning a substrate including copper wiring (hereinafter, sometimes referred to as "cleaning step").

The method for manufacturing a printed wiring board of the present embodiment can further include a step of bonding a resin member to the cleaned substrate (hereinafter, sometimes referred to as a "bonding step"). The resin member contains a resin. Examples of the resin may include thermoplastic resins such as acrylonitrile/styrene copolymer resin (AS resin), acrylonitrile/butadiene/styrene copolymer resin (ABS resin), fluororesins, polyamides, polyethylene, polyethylene terephthalate, polyvinylidene chloride, polyvinyl chloride, polycarbonates, polystyrenes, polysulfones, polypropylene, and liquid crystal polymers, and thermosetting resins such as epoxy resins, phenolic resins, polyimides, polyurethanes, bismaleimide-triazine resins, modified polyphenylene ethers, and cyanate esters, or ultraviolet-curable resins such as ultraviolet-curable epoxy resins and ultraviolet-curable acrylic resins. These resins may be modified with functional groups or may be reinforced with glass fibers, aramid fibers, or other fibers. Specific examples of the resin member may include the build-up film "ABF" manufactured by Ajinomoto Fine-Techno Co., Inc. Examples of the bonding method may include laminate pressing, lamination, coating, injection molding, and transfer molding. If necessary, the resin may be cured by performing heating or irradiation with actinic rays.

The method for manufacturing a printed wiring board of the present embodiment may further include a step of forming a film (namely, a close contact property improving film) on at least the surface of copper wiring (hereinafter, sometimes referred to as "film forming step") between the cleaning step and the bonding step. In the film forming step, a film (namely, a close contact property improving film) can be formed, for example, according to a procedure in which the composition for film formation is brought into contact with at least the surface of copper wiring, and if necessary, the solvent contained in the composition for film formation is dried and removed. The composition for film formation can be an aqueous solution containing a silane coupling agent, for example, a silane coupling agent having a primary amino group and/or a secondary amino group. Example of such a composition for film formation may include the composition for film formation described in Patent Document 4.

Incidentally, the method for manufacturing a printed wiring board of the present embodiment may include a step of roughening the copper wiring surface of the cleaned substrate with a micro-etching solution (hereinafter, sometimes referred to as "surface roughening step") between the cleaning step and the bonding step.

In a case where the method for manufacturing a printed wiring board of the present embodiment includes both the surface roughening step and the film forming step, the surface roughening step is preferably carried out prior to the film forming step.

Before or after each of the steps described above, arbitrary operations such as washing with water and drying may be carried out, if necessary.

### <5. Supplementary liquid>

The supplementary liquid of the present embodiment is a supplementary liquid that is added to the above-described cleaning agent of the present embodiment when the cleaning agent is used continuously or repeatedly. The supplementary liquid of the present embodiment contains a water-soluble carboxylic acid and hydrogen peroxide, and has a pH of less than 2.5. The description of the supplementary liquid overlaps with the description of the cleaning agent and is omitted. Hence, the description of the cleaning agent can also be regarded as the description of the supplementary liquid. Just to be sure, description specific to the supplementary liquid will be added (however, this additional description should not preclude the description of the cleaning agent from being regarded as the description of the supplementary liquid). The concentration of hydrogen peroxide in the supplementary liquid of the present embodiment is preferably higher than that in the cleaning agent of the present embodiment. Hence, the concentration of hydrogen peroxide in the supplementary liquid of the present embodiment may be 0.75% by weight or more. For example, the upper limit of the hydrogen peroxide concentration may be 1.20% by weight, 1.15% by weight, 1.10% by weight, or 1.00% by weight.

### Examples

Next, Examples of the present invention will be described together with Comparative Examples. However, the present invention should not be construed as being limited to the following Examples. Hereinafter, "% by weight" may be simply expressed as "%".

### <Preparation of cleaning solution>

According to Tables 1 to 3, cleaning solutions were prepared by dissolving the components shown in these tables in ion-exchanged water. Hereinafter, the preparation procedure of the cleaning solutions will be described with reference to some examples.

For example, in Example 1, a cleaning solution was prepared by dissolving malic acid and a 35% aqueous hydrogen peroxide solution in ion-exchanged water so that the malic acid concentration was 3% by weight and the hydrogen peroxide concentration was 0.53% by weight.

In Example 3, a cleaning solution was prepared by dissolving malic acid, a 35% aqueous hydrogen peroxide solution, and cresol sulfonic acid in ion-exchanged water so that the malic acid concentration was 1% by weight, the hydrogen peroxide concentration was 0.11% by weight, and the cresol sulfonic acid concentration was 1% by weight.

In Example 9, a cleaning solution was prepared by dissolving malic acid, a 35% aqueous hydrogen peroxide solution, cresol sulfonic acid, and an aqueous sodium chloride solution (specifically, chloride ion standard solution (1000 mg/L) for ion chromatography) in ion-exchanged water so that the malic acid concentration was 3% by weight, the hydrogen peroxide concentration was 0.53% by weight, the cresol sulfonic acid concentration was 1% by weight, and the chloride ion concentration was 1 ppm.

For example, in Example 16, a cleaning solution was prepared by dissolving malic acid, a 35% aqueous hydrogen peroxide solution, and 62.5% sulfuric acid in ion-exchanged water so that the malic acid concentration was 3% by weight, the hydrogen peroxide concentration was 0.53% by weight, and the pH was 0.6.

In Comparative Example 1, a cleaning solution was prepared by dissolving malic acid in ion-exchanged water so that the malic acid concentration was 5% by weight.

In Comparative Example 2, a cleaning solution was prepared by dissolving a 35% aqueous hydrogen peroxide solution in ion-exchanged water so that the hydrogen peroxide concentration was 0.70% by weight.

In Comparative Example 3, a cleaning solution was prepared by dissolving malic acid, a 35% aqueous hydrogen peroxide solution, and a 24% aqueous sodium hydroxide solution in ion-exchanged water so that the malic acid concentration was 3% by weight, the hydrogen peroxide concentration was 0.53% by weight, and the pH was 3.9.

### <Etching rate · gravimetric method>

A test piece of 100 mm × 100 mm was cut out from a copper electroplated substrate. The test piece was shaken (that is, rocked) for 30 seconds in a state of being immersed in a 6.25% by weight aqueous sulfuric acid solution, and then washed with water and dried. In other words, the test piece was subjected to a rust removing treatment. This was used as a test piece for examining the etching rate (hereinafter referred to as "test piece for etching rate examination"). The weight of the test piece for etching rate examination (hereinafter referred to as "weight before cleaning") was measured using a precision balance with four decimal places.

The test piece for etching rate examination was shaken for 60 seconds in a state of being immersed in the cleaning solution at 30°C, washed with water immediately after being taken out from the cleaning solution, and dried using a dryer. Next, the weight of the test piece for etching rate examination (hereinafter referred to as "weight after cleaning") was measured using a precision balance with four decimal places.

The difference between the weight before cleaning and the weight after cleaning, that is, the amount of weight change after cleaning, was determined. The etching depth was determined based on the amount of weight change, the area of the test piece for etching rate examination, and the density of copper. Specifically, the etching depth was determined by the following equation: Etching depth (cm) = amount of weight change (g) ÷ area (cm2) ÷ density (g/cm3)

The etching depth was determined assuming that the density of copper was 8.92 g/cm³. The etching depth was determined assuming that the area of the test piece for etching rate examination was 200 cm² since the copper electroplated substrate was a double-sided board.

The etching rate (µm/min) was determined based on the etching depth.

### <Etching rate · copper wafer X-ray fluorescence analysis>

A substrate was prepared in which a sputtered copper layer having a thickness of 2000 angstroms was formed on a silicon wafer. In other words, a substrate including a silicon wafer and a sputtered copper layer having a thickness of 2000 angstroms was prepared. A test piece of about 10 mm × about 10 mm was cut out from this substrate. The test piece was shaken for 60 seconds in a state of being immersed in the cleaning solution at 30°C, washed with water immediately after being taken out from the cleaning solution, and dried using a dryer. The intensity of copper in this test piece was measured using an X-ray fluorescence analyzer (manufactured by Hitachi High-Tech Corporation), and the thickness of the sputtered copper layer was calculated. From this calculation result, the etching rate (nm/min) was calculated.

### <Copper oxide removing properties>

A copper electroplated substrate was heated (that is, baked) at 150°C for 1 hour, and then a test piece of 50 mm × 50 mm was cut out from this substrate. This test piece was shaken for 60 seconds in a state of being immersed in the cleaning solution at 30°C, washed with water immediately after being taken out from the cleaning solution, and dried using a dryer. The L* (hereinafter sometimes referred to as "L value") of this test piece was measured using a color difference meter (CR-10 Plus manufactured by Konica Minolta Inc.). It indicates that a greater amount of copper oxide has been removed as the L value is higher. From the results of the preliminary experiment, it is considered that a cleaning solution that have achieved an L value of 78 or more has cleaning action (specifically, rust removing action) equal to or greater than that of 6.25% by weight sulfuric acid. It was also visually evaluated whether rust remained on this test piece. The place where rust remains (namely, rust remaining place) is dark, resulting in uneven coloring. In a case where unevenness was observed, it was judged that rust remained. In the table, a case where it was judged that rust remained is denoted as Poor and a case where it was judged that rust did not remain is denoted as Excellent.

### <Organic substance cleaning properties>

A solution (hereinafter referred to as "FE solution") was prepared by dissolving sulfuric acid, hydrogen peroxide, and 5-aminotetrazole in ion-exchanged water so that the concentrations thereof were 6.25% by weight, 3.5% by weight, and 0.1% by weight, respectively. Meanwhile, a test piece of 300 mm × 300 mm was cut out from a copper electroplated substrate. The test piece was immersed in the FE solution at 25°C for 30 seconds, then washed with water and dried. This test piece (that is, the test piece treated with FE solution) was cut into a size of 50 mm × 50 mm, and subjected to the measurement of infrared absorption spectrum using a Fourier transform infrared spectrophotometer (FT-IR) by the reflection absorption spectroscopy (RAS) (the measurement conditions will be described later). The test piece treated with FE solution was shaken for 60 seconds in a state of being immersed in the cleaning solution at 30°C, washed with water immediately after being taken out from the cleaning solution, and dried using a dryer (that is, the test piece treated with FE solution was cleaned). Next, the infrared absorption spectrum of this test piece (namely, the test piece after cleaning) was also measured by RAS using FT-IR. The degree of cleaning was calculated from the peak area near 3350 cm⁻¹ in the infrared absorption spectrum before cleaning and the peak area near 3350 cm⁻¹ in the infrared absorption spectrum after cleaning by the following equation. It indicates that organic residue removing properties are superior as the value of the degree of cleaning is larger. Degree of cleaning = { (peak area before cleaning - peak area after cleaning) /peak area before cleaning} ×100

The infrared absorption spectra (specifically, both the infrared absorption spectrum before cleaning and the infrared absorption spectrum after cleaning) were measured using the "NICOLET380" manufactured by Thermo Fisher Scientific Inc. by the reflection absorption spectroscopy (RAS) under conditions of detector: DLaTGS/KBr, accessory: RAS, resolution: 8 cm⁻¹, number of accumulations: 16, and incidence angle: 75 degrees.

Regarding the calculation of the peak area (namely, the peak area near 3350 cm⁻¹), in the infrared absorption spectrum in which the horizontal axis was wave number and the vertical axis was absorbance, the straight line connecting the measurement point of wave number 3263 cm⁻¹ and the measurement point of wave number 3529 cm⁻¹ was taken as the baseline, and the area of the region enclosed by this baseline and the curve of the infrared absorption spectrum was calculated as the peak area of organic residues (namely, the peak area near 3350 cm⁻¹).

**[Table 1]**

| | | **Carboxylic acid** | | **35% H₂O₂** | **100% H₂O₂** | **62.5%Sulfuric acid** | **24% NaOH** | **Cl⁻** | **Other additives** | **PH** | **Etching rate** | | **Copper oxide removing properties** | | **Organic su bstance cleaning properties** |
|---|---|---|---|---|---|---|---|---|---|---|---|---|---|---|---|
| | | **Kind** | **Conc.** | **Conc.** | **Conc.** | **Conc.** | **Conc.** | **Conc.** | | | **Gravimetric method** | **Copper wafer X-ray fl uorescence analvsis** | **Appearance judgment** | **150°C 60 min** | |
| | | | **wt%** | **wt%** | **wt%** | **wt%** | **wt%** | **ppm** | | | **ER (µm/min)** | **ER (nm/min)** | | **L value** | **Degree of cleaning** |
| **Example e** | **1** | **Malic acid** | **3** | **1.5** | **0.53** | **0.00** | **0.00** | **0** | **-** | **2.2** | **0.055** | **56** | **Excellent** | **87** | **85%** |
| | **2** | **Malic acid** | **3** | **1.5** | **0.53** | **0.60** | **0.00** | **0** | **-** | **1.3** | **0.058** | **48** | **Excellent** | **82** | **95%** |
| | **3** | **Malic acid** | **1** | **0.3** | **0.11** | **0.00** | **0.00** | **0** | **Cresol sulfonic acid 1%** | **1.5** | **0.031** | **18** | **Excellent** | **86** | **79%** |
| | **4** | **Malic acid** | **1** | **2.1** | **0.74** | **0.00** | **0.00** | **0** | **Cresol sulfonic acid 1%** | **1.5** | **0.156** | **137** | **Excellent** | **86** | **91%** |
| | **5** | **Malic acid** | **3** | **2.1** | **0.74** | **0.00** | **0.00** | **0** | **Cresol sulfonic acid 1%** | **1.4** | **0.119** | **117** | **Excellent** | **85** | **93%** |
| | **6** | **Malic acid** | **7** | **0.3** | **0.11** | **0.00** | **0.00** | **0** | **Cresol sulfonic acid 1%** | **1.3** | **0.020** | **16** | **Excellent** | **86** | **73%** |
| | **7** | **Malic acid** | **7** | **1.5** | **0.53** | **0.00** | **0.00** | **0** | **Cresol sulfonic acid 1%** | **1.3** | **0.080** | **63** | **Excellent** | **86** | **89%** |
| | **8** | **Malic acid** | **7** | **2.1** | **0.74** | **0.00** | **0.00** | **0** | **Cresol sulfonic acid 1%** | **1.3** | **0.103** | **94** | **Excellent** | **86** | **94%** |
| | **9** | **Malic acid** | **3** | **1.5** | **0.53** | **0.00** | **0.00** | **1** | **Cresol sulfonic acid 1%** | **1.4** | **0.099** | **86** | **Excellent** | **80** | **90%** |
| | **10** | **Malic acid** | **1** | **0.3** | **0.11** | **0.00** | **0.00** | **0.1** | **Cresol sulfonic acid 1%** | **1.5** | **0.024** | **12** | **Excellent** | **81** | **79%** |
| | **11** | **Malic acid** | **7** | **0.3** | **0.11** | **0.00** | **0.00** | **0.5** | **Cresol sulfonic acid 1%** | **1.3** | **0.029** | **17** | **Excellent** | **85** | **76%** |
| | **12** | **Malic acid** | **7** | **1.5** | **0.53** | **0.00** | **0.00** | **2** | **Cresol sulfonic acid 1%** | **1.3** | **0.113** | **76** | **Excellent** | **79** | **88%** |
| | **13** | **Malic acid** | **0.5** | **0.3** | **0.11** | **0.00** | **0.00** | **0** | **Cresol sulfonic acid 0.5%** | **1.9** | **0.021** | **25** | **Excellent** | **85** | **77%** |
| | **14** | **Malic acid** | **15** | **2.1** | **0.74** | **0.00** | **0.00** | **0** | **Cresol sulfonic acid 0.5%** | **1.4** | **0.077** | **73** | **Excellent** | **85** | **88%** |
| | **15** | **Malic acid** | **20** | **2.1** | **0.74** | **0.00** | **0.00** | **0** | **Cresol sulfonic acid 0.5%** | **1.3** | **0.097** | **87** | **Excellent** | **85** | **89%** |
| | **16** | **Malic acid** | **3** | **1.5** | **0.53** | **4.53** | **0.00** | **0** | **-** | **0.6** | **0.133** | **88** | **Excellent** | **84** | **82%** |
| | **17** | **Malic acid** | **3** | **1.5** | **0.53** | **1.81** | **3.30** | **0** | **-** | **1.9** | **0.066** | **81** | **Excellent** | **86** | **79%** |
| | **18** | **Acetic acid** | **0.5** | **0.3** | **0.11** | **0.00** | **0.00** | **0** | **Cresol sulfonic acid 1%** | **1.7** | **0.066** | **10** | **Excellent** | **80** | **73%** |
| | **19** | **Acetic acid** | **1** | **0.3** | **0.11** | **0.00** | **0.00** | **0** | **Cresol sulfonic acid 1%** | **1.5** | **0.045** | **19** | **Excellent** | **81** | **79%** |
| | **20** | **Acetic acid** | **3** | **1** | **0.35** | **0.00** | **0.00** | **0** | **Cresol sulfonic acid 1%** | **1.7** | **0.145** | **114** | **Excellent** | **86** | **90%** |

**[Table 2]**

| | | **Carboxylic acid** | | **35% H₂O₂** | **100% H₂O₂** | **62.5% Sulfuric acid** | **24% NaOH** | **Cl⁻** | **Other additives** | **PH** | **Etching rate** | | **Copper oxide removing properties** | | **Organic substance cleaning properties** |
|---|---|---|---|---|---|---|---|---|---|---|---|---|---|---|---|
| | | **Kind** | **Conc.** | **Conc.** | **Conc.** | **Conc.** | **Conc.** | **Conc.** | | | **Gravimetric method** | **Copper wafer X-ray fluorescence analysis** | **Appearance judgment** | **150°C 60 min** | |
| | | | **wt%** | **wt%** | **wt%** | **wt%** | **wt%** | **ppm** | | | **ER (µm/min)** | **ER (nm/min)** | | **Lvalue** | **Degree of cleaning** |
| | **21** | **Acetic acid** | **5** | **1** | **0.35** | **0.00** | **0.00** | **0** | **Cresol sulfonic acid 1%** | **1.7** | **0.122** | **99** | **Excellent** | **84** | **82%** |
| | **22** | **Acetic acid** | **7** | **0.3** | **0.11** | **0.00** | **0.00** | **0** | **Cresol sulfonic acid 1%** | **1.6** | **0.038** | **33** | **Excellent** | **85** | **71%** |
| | **23** | **Acetic acid** | **7** | **1** | **0.35** | **0.00** | **0.00** | **0** | **Cresol sulfonic acid 1%** | **1.6** | **0.115** | **87** | **Excellent** | **83** | **81%** |
| | **24** | **Acetic acid** | **15** | **0.3** | **0.11** | **0.00** | **0.00** | **0** | **Cresol sulfonic acid 1%** | **1.5** | **0.041** | **13** | **Excellent** | **84** | **72%** |
| | **25** | **Acetic acid** | **20** | **0.3** | **0.11** | **0.00** | **0.00** | **0** | **Cresol sulfonic acid 1%** | **1.5** | **0.033** | **44** | **Excellent** | **84** | **76%** |
| | **26** | **Acetic acid** | **20** | **2.1** | **0.74** | **0.00** | **0.00** | **0** | **Cresol sulfonic acid 1%** | **1.5** | **0.128** | **155** | **Excellent** | **85** | **96%** |
| | **27** | **Formic acid** | **2.6** | **1** | **0.35** | **0.00** | **0.00** | **0** | **Cresol sulfonic acid 0.5%** | **2.0** | **0.141** | **126** | **Excellent** | **85** | **73%** |
| | **28** | **Formic acid** | **6.6** | **1** | **0.35** | **0.00** | **0.00** | **0** | **Cresol sulfonic acid 0.3%** | **1.9** | **0.139** | **117** | **Excellent** | **84** | **73%** |
| | **29** | **Propionic acid** | **2** | **1** | **0.35** | **0.00** | **0.00** | **0** | **Cresol sulfonic acid 0.5%** | **1.7** | **0.115** | **12** | **Excellent** | **87** | **78%** |
| **Example** | **30** | **Propionic acid** | **6** | **1** | **0.35** | **0.00** | **0.00** | **0** | **Cresol sulfonic acid 0.5%** | **2.0** | **0.031** | **7** | **Excellent** | **88** | **82%** |
| | **31** | **Maleic acid** | **2** | **1** | **0.35** | **0.00** | **0.00** | **0** | **Cresol sulfonic acid 1%** | **1.4** | **0.152** | **139** | **Excellent** | **86** | **99%** |
| | **32** | **Maleic acid** | **5** | **1** | **0.35** | **0.00** | **0.00** | **0** | **Cresol sulfonic acid 1%** | **1.2** | **0.127** | **110** | **Excellent** | **85** | **95%** |
| | **33** | **Succinic acid** | **0.5** | **0.3** | **0.11** | **0.00** | **0.00** | **0** | **Cresol sulfonic acid 1%** | **1.7** | **0.057** | **29** | **Excellent** | **83** | **72%** |
| | **34** | **Succinic acid** | **1** | **0.3** | **0.11** | **0.00** | **0.00** | **0** | **Cresol sulfonic acid 1%** | **1.6** | **0.039** | **33** | **Excellent** | **85** | **72%** |
| | **35** | **Succinic acid** | **3** | **2.1** | **0.74** | **0.00** | **0.00** | **0** | **Cresol sulfonic acid 1%** | **1.7** | **0.113** | **106** | **Excellent** | **86** | **91%** |
| | **36** | **Lactic acid** | **2.2** | **1** | **0.35** | **0.00** | **0.00** | **0** | **Cresol sulfonic acid 0.5%** | **1.9** | **0.132** | **70** | **Excellent** | **86** | **81%** |
| | **37** | **Lactic acid** | **2.2** | **1.8** | **0.63** | **0.00** | **0.00** | **0** | **Cresol sulfonic acid 0.5%** | **2.0** | **0.170** | **145** | **Excellent** | **84** | **87%** |
| | **38** | **Lactic acid** | **5.5** | **1** | **0.35** | **0.00** | **0.00** | **0** | **Cresol sulfonic acid 0.5%** | **1.8** | **0.084** | **50** | **Excellent** | **86** | **76%** |
| | **39** | **Lactic acid** | **5.5** | **1.8** | **0.63** | **0.00** | **0.00** | **0** | **Cresol sulfonic acid 0.5%** | **1.9** | **0.175** | **98** | **Excellent** | **86** | **87%** |
| | **40** | **Lactic acid** | **22** | **1.8** | **0.63** | **0.00** | **0.00** | **0** | **Cresol sulfonic acid 0.5%** | **1.5** | **0.050** | **25** | **Excellent** | **87** | **75%** |

**[Table 3]**

| | | **Carboxylic acid** | | **35% H₂O₂** | **100% H₂O₂** | **62.5% Sulfuric acid** | **24% NaOH** | **Cl⁻** | **Other additives** | **PH** | **Etching rate** | | **Copper oxide removing properties** | | **Organic substance cleaning properties** |
|---|---|---|---|---|---|---|---|---|---|---|---|---|---|---|---|
| | | **Kind** | **Conc.** | **Conc.** | **Conc.** | **Conc.** | **Conc.** | **Conc.** | | | **Gravimetric method** | **Copper wafer X-ray fluorescence analysis** | **Appearance judgment** | **150°C 60 min** | |
| | | | **wt%** | **wt%** | **wt%** | **wt%** | **wt %** | **ppm** | | | **ER (µm/min)** | **ER (nm/min)** | | **L value** | **Degree of cleaning** |
| | **41** | **Citric acid** | **2.2** | **1** | **0.35** | **0.00** | **0.00** | **0** | **Cresol sulfonic acid 1%** | **1.6** | **0.101** | **72** | **Excellent** | **86** | **80%** |
| | **42** | **Citric acid** | **2.2** | **1.8** | **0.63** | **0.00** | **0.00** | **0** | **Cresol sulfonic acid 1%** | **1.9** | **0.159** | **154** | **Excellent** | **86** | **92 %** |
| | **43** | **Citric acid** | **5.5** | **1** | **0.35** | **0.00** | **0.00** | **0** | **Cresol sulfonic acid 1%** | **1.6** | **0.080** | **49** | **Excellent** | **86** | **80%** |
| | **44** | **Citric acid** | **5.5** | **1.8** | **0.63** | **0.00** | **0.00** | **0** | **Cresol sulfonic acid 0.5%** | **1.8** | **0.138** | **104** | **Excellent** | **86** | **92 %** |
| | **45** | **Citric acid** | **20** | **1.8** | **0.63** | **0.00** | **0.00** | **0** | **Cresol sulfonic acid 0.5%** | **1.4** | **0.117** | **78** | **Excellent** | **85** | **91%** |
| | **46** | **Glycine** | **2** | **1** | **0.35** | **1.51** | **0.00** | **0** | **Cresol sulfonic acid 1%** | **1.9** | **0.107** | **89** | **Excellent** | **86** | **82%** |
| **Example** | **47** | **Glycine** | **5** | **1.8** | **0.63** | **4.53** | **0.00** | **0** | **Cresol sulfonic acid 1%** | **1.7** | **0.147** | **122** | **Excellent** | **85** | **86%** |
| | **48** | **Glycine** | **20** | **1.8** | **0.63** | **15.10** | **0.00** | **0** | **Cresol sulfonic acid 1%** | **2.0** | **0.085** | **70** | **Excellent** | **86** | **85%** |
| | **49** | **β-Alanine** | **2** | **1** | **0.35** | **1.51** | **0.00** | **0** | **Cresol sulfonic acid 1%** | **2.1** | **0.084** | **69** | **Excellent** | **87** | **87%** |
| | **50** | **β-Alanine** | **2** | **1.8** | **0.63** | **1.51** | **0.00** | **0** | **Cresol sulfonic acid 1%** | **2.2** | **0.188** | **147** | **Excellent** | **86** | **91%** |
| | **51** | **β-Alanine** | **5** | **1** | **0.35** | **4.53** | **0.00** | **0** | **Cresol sulfonic acid 1%** | **1.7** | **0.093** | **71** | **Excellent** | **86** | **80%** |
| | **52** | **Lactic acid** | **5.5** | **1.8** | **0.63** | **0.00** | **0.00** | **0.5** | **Cresol sulfonic acid 0.5%** | **1.9** | **0.082** | **91** | **Excellent** | **84** | **85%** |
| | **53** | **Glycine** | **2** | **1** | **0.35** | **1.51** | **0.00** | **1** | **Cresol sulfonic acid 1%** | **1.9** | **0.094** | **77** | **Excellent** | **85** | **79%** |
| | **54** | **Acetic acid** | **3** | **1.5** | **0.53** | **0.15** | **0.00** | **0.5** | **-** | **2.0** | **0.160** | **154** | **Excellent** | **80** | **91%** |
| **Comparative Example** | **1** | **Malic acid** | **5** | **0** | **0.00** | **0.00** | **0.00** | **0** | **-** | **2.0** | **0.010** | **0** | **Excellent** | **83** | **40%** |
| | **2** | **-** | **0** | **2** | **0.70** | **0.00** | **0.00** | **0** | **-** | **5.4** | **< 0.01** | **0** | **Poor** | **29** | **22%** |
| | **3** | **Malic acid** | **3** | **1.5** | **0.53** | **0.00** | **3.30** | **0** | **-** | **3.9** | **0.079** | **79** | **Poor** | **65** | **98%** |
| | **4** | **β-Alanine** | **1.5** | **15** | **5.25** | **0.00** | **-** | **0** | **Aminotetrazole 0.1%** | **2.2** | **0.087** | **103** | **Poor** | **73** | **79%** |
| | | | | | | | | | **Nitric acid 1.2%** | | | | | | |
| | **5** | **Citric acid** | **3** | **60** | **21** | **0.00** | **-** | **0** | **Aminotetrazole 0.1%** | **1.5** | **0.206** | **200 <** | **Poor** | **52** | **84%** |
| | **6** | **Malic acid** | **2** | **2.9** | **1.00** | **0.00** | **1.91** | **0** | **-** | **2.3** | **0.202** | **200 <** | **Excellent** | **85** | **86%** |
| | **7** | **Malic acid** | **5** | **11.4** | **4.00** | **0.00** | **3.07** | **0** | **-** | **2.0** | **0.421** | **200 <** | **Excellent** | **80.3** | **83%** |

In Comparative Example 1 in which a cleaning solution that contained malic acid but did not contain hydrogen peroxide was used, the copper oxide removing properties were favorable but the organic substance cleaning properties were not favorable. In Comparative Example 2 in which a cleaning solution that contained hydrogen peroxide but did not contain malic acid was used, the copper oxide removing properties and the organic substance cleaning properties were poor. In Comparative Example 3 in which a cleaning solution that contained malic acid and hydrogen peroxide and had a pH of 3.9 was used, the copper oxide removing properties were not favorable. In Comparative Example 6 in which a cleaning solution that contained malic acid and hydrogen peroxide at 1.00% by weight was used, the copper oxide removing properties and the organic substance cleaning properties were favorable but the etching rate was excessively high. In Comparative Example 7 in which a cleaning solution that contained malic acid and hydrogen peroxide at 4.00% by weight was used, the copper oxide removing properties and the organic substance cleaning properties were favorable but the etching rate was excessively high.

On the other hand, in Examples 1 to 54, the copper oxide removing properties and the organic substance cleaning properties were favorable as well as the etching rate was not excessively high.

### <Resin adhesive properties>

A test piece of 100 mm × 100 mm was cut out from electrolytically plated copper foil, and the surface of the test piece was treated with a flash etching solution from MEC COMPANY LTD., then washed with water and dried. This flash etching solution contains a nitrogen-containing heterocyclic compound.

This test piece, namely, the flash-etched test piece was shaken for 60 seconds in a state of being immersed in the cleaning solution (specifically, the cleaning solutions prepared in Examples 11, 52, 53, and 54 and Comparative Example 1) at 30°C, washed with water immediately after being taken out from the cleaning solution, and dried using a dryer.

This test piece, namely, the cleaned test piece was shaken for 60 seconds in a state of being immersed in a film forming solution (the preparation method of which will be described later) at 25°C, washed with water immediately after being taken out from the film forming solution, and dried using a dryer. For this test piece, namely, the test piece subjected to film formation, the Si-O peak area near 1100 cm⁻¹ in the infrared absorption spectrum was calculated (the measurement conditions will be described later).

The test piece subjected to film formation was heated at 130°C for 60 minutes in the air for thermal degradation, then a build-up film ("ABF" manufactured by Ajinomoto Fine-Techno Co., Inc.) was vacuum laminated on this test piece (namely, the test piece after thermal degradation), and then heating was performed under the recommended conditions. The build-up film was thus thermally cured. According to such a procedure, a resin layer (namely, a cured build-up film) was formed on one surface of the copper foil subjected to film formation. A 10 mm wide cut was made in the copper foil from the side opposite to the surface on which a resin layer was formed, the tip of the copper foil was grasped with a gripper, and a 90° peel test was carried out in conformity with JIS C6481 at a peel speed of 50 mm/min over a length of 6 mm to measure the peel strength.

The film forming solution was prepared by the method described in Example 5 of Japanese Patent No. 6,779,557. Specifically, 3-(2-aminoethylamino)propyltrimethoxysilane, CuSO₄·5H₂O, and KBr were dissolved in ion-exchanged water so that the concentrations thereof were 0.4% by weight, 0.2% by weight, and 0.3% by weight, respectively, and the pH was then adjusted to 5.0 to prepare a film forming solution.

The infrared absorption spectrum was measured using the "NICOLET380" manufactured by Thermo Fisher Scientific Inc. by the reflection absorption spectroscopy (RAS) under conditions of detector: DLaTGS/KBr, accessory: RAS, resolution: 8 cm⁻¹, number of accumulations: 16, and incidence angle: 75 degrees.

Regarding the calculation of the Si-O peak area, in the infrared absorption spectrum in which the horizontal axis was wave number and the vertical axis was absorbance, the straight line connecting the measurement point of wave number 1070 cm⁻¹ and the measurement point of wave number 1180 cm⁻¹ was taken as the baseline, and the area of the region enclosed by this baseline and the curve of the infrared absorption spectrum was calculated as the Si-O peak area.

**[Table 4]**

| | | **Si-O Area** | **Peel strength (N/mm)** |
|---|---|---|---|
| **Example** | **11** | **0.90** | **0.63** |
| | **52** | **1.52** | **0.56** |
| | **53** | **0.88** | **0.64** |
| | **54** | **0.88** | **0.63** |
| **Comparative Example** | **1** | **1.26** | **0.33** |

In the case of performing a treatment in which cleaning was performed with a cleaning solution (specifically, the cleaning solutions prepared in Examples 11, 52, 53 and 54) of which the copper oxide removing properties and the organic substance cleaning properties were favorable, the peel strength was excellent. On the other hand, in the case of performing a treatment in which cleaning was performed with a cleaning solution (specifically, the cleaning solution prepared in Comparative Example 1) that was inferior in organic substance cleaning properties to the cleaning solutions prepared in these examples (specifically, Examples 11, 52, 53 and 54), the peel strength was inferior. In Examples 11, 52, 53, and 54 and Comparative Example 1, a Si-O peak was observed, and therefore it was judged that a film was formed by the film forming solution.

## Claims

1. A cleaning agent for substrates including copper wiring, comprising:
a water-soluble carboxylic acid; and
hydrogen peroxide, wherein
a concentration of the hydrogen peroxide is less than 0.75% by weight, and
a pH of the cleaning agent is less than 2.5.

2. The cleaning agent according to claim 1, which substantially does not comprise a nitrogen-containing heterocyclic compound.

3. The cleaning agent according to claim 1, which does not comprise a nitrogen-containing heterocyclic compound.

4. The cleaning agent according to claim 1, wherein the water-soluble carboxylic acid is at least one carboxylic acid selected from the group consisting of formic acid, acetic acid, propionic acid, glycolic acid, oxalic acid, malonic acid, succinic acid, maleic acid, lactic acid, malic acid, citric acid, glycine, α-alanine, and β-alanine.

5. The cleaning agent according to claim 1, wherein a concentration of the water-soluble carboxylic acid is 0.2% by weight or more.

6. The cleaning agent according to claim 1, wherein a concentration of the hydrogen peroxide is 0.05% by weight or more.

7. The cleaning agent according to claim 1, wherein a chloride ion concentration is 0.05 ppm or more.

8. The cleaning agent according to claim 1, which is used to clean the substrate before a film for improving close contact properties between the copper wiring and a resin member is formed on a surface of the copper wiring.

9. A cleaning method comprising a step of cleaning a substrate including copper wiring with the cleaning agent according to any one of claims 1 to 8.

10. A supplementary liquid to be added to the cleaning agent according to any one of claims 1 to 8 when the cleaning agent is used continuously or repeatedly, the supplementary liquid comprising:
a water-soluble carboxylic acid; and
hydrogen peroxide, wherein
a pH of the supplementary liquid is less than 2.5.
